# EUROPEAN PATENT APPLICATION

(11) **EP 1 555 853 A2**
(43) Date of publication of application: **20.07.2005**
(21) Application number: 04028352.5
(22) Date of filing: 30.11.2004
(51) Int. Cl.: H05B 33/10

(54) **Mask, method for manufacturing thereof, method for manufacturing organic electroluminescent device, and organic electroluminescent device**

(30) Priority: 02.12.2003 JP 2003403070
(71) Applicant: SEIKO EPSON CORPORATION, Tokyo 160-0811 (JP)
(72) Inventor: Kuwahara, Takayuki, Suwa-shi, Nagano-ken 392-8502 (JP); Yotsuya, Shinichi, Suwa-shi, Nagano-ken 392-8502 (JP)
(74) Representative: HOFFMANN - EITLE

(57) **Abstract**

A mask comprises a first substrate (10) having a first aperture (12) and at least one second substrate (20) having a plurality of second apertures (22) serving as mask apertures of the mask. The second apertures (22) are placed in the first aperture (12), and the at least one second substrate (20) is partially bonded to the first substrate (10).

## Description

### Field of the Invention

The present invention relates to a mask and a method for manufacturing thereof, to a method for manufacturing an organic electroluminescent (EL) device, and to an organic EL device.

### Background of the Invention

As a method for manufacturing a low-molecular full-colour organic EL panel, there is a method in which a deposition pattern is selectively formed through a mask so as to separately colour each red, blue, and green luminescent layer on a glass substrate. For example, when a metal mask is used as the mask, deposition is conducted in a condition where the mask is adhered to one side of the glass substrate by a permanent magnet placed on the other side of the glass substrate. However, when a large-sized panel is manufactured with a metal mask, there is a problem in which a position of the mask deviates from that of the glass substrate, since there is a large difference between a thermal expansion coefficient of the mask and that of the glass substrate.

Therefore, there have been developments of a deposition mask that has less difference in the thermal expansion coefficient between the mask and the glass substrate and that uses a single crystalline Si wafer that can be more finely processed by micro electro mechanical systems (MEMS). Also, Japanese Unexamined Patent Publication No. 2003-100460, for example, discloses a technique in which the mask strength is increased by mounting a plurality of small Si mask chips on a large-sized substrate material provided with apertures.

However, by the technique of the above-mentioned Japanese Unexamined Patent Publication No. 2003-100460, a slight bending occurs when fixing a Si mask chip to an aperture. Because of this bending, a gap is created between the mask and a glass substrate used as a material to be deposited on (a layer-formation object material), and the resulting deposition pattern may possibly be unclear.

### Disclosure of the Invention

In view of these issues, the present invention aims at providing a mask that is reliable, for example, for deposition and that can form a desired high-precision layer pattern on, for example, a glass substrate used as a layer-formation object material, and a method for manufacturing thereof. Further, the present invention aims to provide a method for manufacturing an organic EL device using the mask.

To solve the problems, the mask of the present invention includes a first substrate having a first aperture and at least one second substrate having second apertures serving as mask apertures of the mask of the invention, wherein the second apertures are placed in the first aperture and the at least one second substrate is partially bonded to the first substrate.

Upon a series of inquiries made by the present inventors, it has been discovered that the cause of the bending generated when fixing the above-mentioned Si mask chip to a large-sized substrate material was in the fixation method, and thereby the present invention has come to completion. That is to say that, when a second substrate having an aperture for a mask is bonded to a first substrate having a first aperture, a problem of the bending created on the substrates shall be solved by partially bonding the second substrate to the first substrate even if an expansion and shrinkage of the substrates occur, since the expansion and shrinkage of the substrates will be lessened at the non-bonded parts, and a desired high-precision layer pattern can be formed by, for example, depositing the mask. As a result, a gap between a mask and a layer-formation object material does not easily appear, and thereby a desired high-precision layer pattern can be formed. Moreover, because the second substrate is reinforced by the first substrate according to the present invention, the mask shall have a very high strength.

Additionally, the second substrate and the first substrate can be bonded with an adhesive agent, which can be formed partially on one second substrate. In this case, also, a desired high-precision layer pattern can be formed. Moreover, since the bonding procedure using an adhesive agent is very simple, it is possible to provide the mask at a low cost. Further, the second substrate can have a structure in that it can be bonded to the first substrate over a plurality of points, and that, when an adhesive agent is used as described, the adhesive agent can be arranged over a plurality of places for one second substrate.

Further, in a preferred embodiment, the second substrate is formed rectangularly, and only a corner of the second substrate is partially bonded to the first substrate. Also, it is possible that only one side of each second substrate that opposes the other side of a primary surface of the respective second substrate is bonded partially to the first substrate. Moreover, the second substrate can be bonded partially to the first substrate close to a center of a side having the largest expansion of all sides of a primary surface of the second substrate. In any of these structures, a desired high-precision layer pattern can be formed.using the mask.

Also, more than two second substrates can be bonded to the first substrate sharing the same adhesive agent. This can simplify the adhesive agent supply procedure at the same time as it can form a desired high-precision layer pattern using the mask.

Further, an alignment mark used when bonding the second substrate to the first substrate can be placed on each substrate, with each substrate being bonded in close proximity to the alignment mark. In this case, the procedure for aligning the first substrate and the second substrate will be relatively easy compared to when forming the bonding portion apart from an alignment mark.

For the mask of the present invention, the second substrate can be formed with a silicon wafer. By forming the second substrate with a silicon wafer, the difference between a thermal expansion coefficient of the mask and that of the glass substrate or the like as a layer-formation object material will be smaller, preventing the position of the mask from deviating from the position of the layer-formation object material.

To solve the aforementioned problem, the method for manufacturing the mask of the present invention includes the steps of: laminating a first substrate having a first aperture and at least one second substrate having second apertures serving as mask apertures so that the second apertures are placed in the first aperture, and, in the laminating step, partially bonding the at least one second substrate to the first substrate. By this manufacturing method, the above-described mask of the present invention can be suitably manufactured. Also, in the laminating step, the second substrate is partially bonded to the first substrate preferably using an adhesive agent, which is partially formed on the first substrate and/or the second substrate.

Further, by using a rectangular primary surface of a substrate as the second substrate, only a corner of the second substrate may be partially bonded to the first substrate in the laminating step. Also, in the laminating step, only one side each that opposes the other of the second substrate may be partially bonded to the first substrate. Moreover, in the laminating step, the second substrate may be partially bonded to the first substrate close to a center of a side having the largest expansion coefficient of all sides of a primary surface of the second substrate.

Next, the method of manufacturing an organic EL device according to the present invention includes forming an organic EL element using the mask of the present invention. Of organic EL elements, a luminescent material (organic material) that forms a luminescent layer, for example, can be formed into a layer by deposition. By conducting deposition through the mask, a highly reliable organic EL device having a luminescent layer in a predetermined pattern may be obtained.

### Description of the Preferred Embodiments

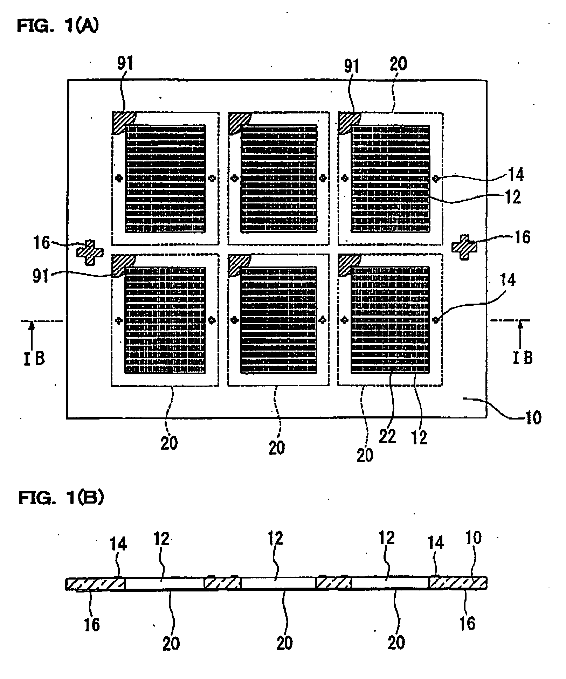

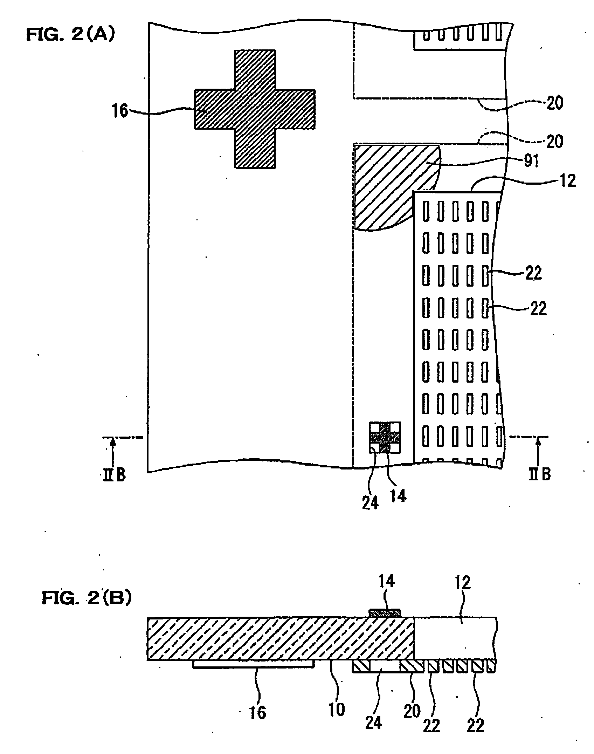

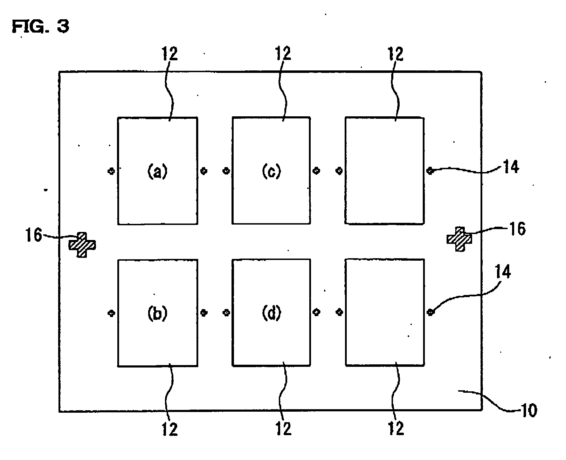

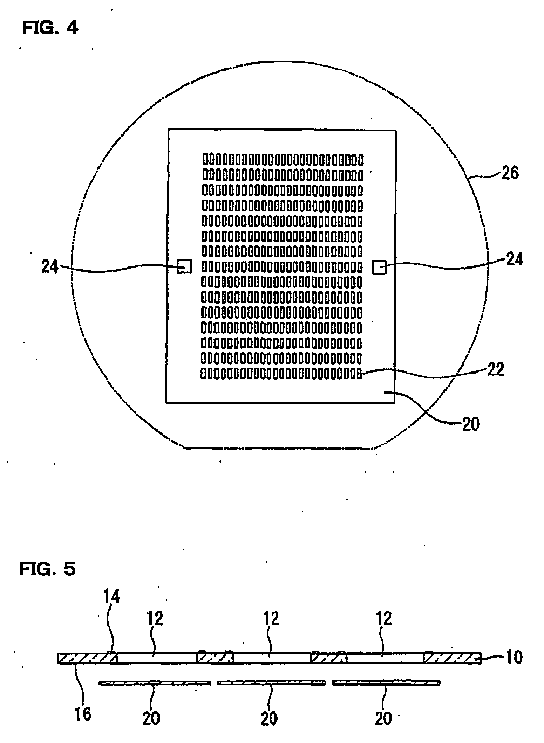

Preferred embodiments of the present invention will now be described with reference to the accompanying drawings. FIG. 1(A) is a flat pattern view of the mask according to an embodiment of the present invention, and FIG. 1(B) is a cross sectional view taken on a IB-IB line of FIG. 1(A). FIG. 2(A) is a flat pattern view of an enlarged principal part of the mask in accordance with the embodiment of the present invention, and FIG. 2(B) is a cross sectional view taken on a IIB-IIB line of FIG. 2(A). The mask of the present embodiment is composed of a first substrate 10 and at least one (in FIG. 1(A), a plurality of) second substrate 20. FIG. 3 is a flat pattern view showing a rough structure of the first substrate 10, and FIG. 4 is a flat pattern view showing a rough structure of the second substrate 20.

The first substrate 10 may be composed of a transparent substrate such as a glass substrate. On the first substrate 10, at least one (in FIG. 1(A), a plurality of) aperture is formed rectangularly so that the second substrates 20 can be fit into the apertures 12. Therefore the first substrate 10 may be called frames. Here, an area of the aperture 12 is structured to be smaller than an area of a primary surface of the second substrate 20. However, the aperture 12 is larger than a region on the second substrate 20 on which a plurality of through-holes 22 are formed, as will be described later.

On the first substrate 10, a first alignment mark 14 is formed. The first alignment mark 14 is used for aligning the first substrate 10 with the second substrate 20 when bonding them together. The first alignment mark 14 may be formed with a metal film or by etching. Also, on the first substrate 10, a mask-positioning mark 16 is formed. The mask-positioning mark 16 is used for positioning the mask of the present embodiment when conducting deposition using the mask. The mask-positioning mark 16 can also be formed with a metal material. Further, the mask-positioning mark 16 may be formed on the second substrate 20.

The second substrate 20 is formed rectangularly, similarly outlining the aperture 12, and a plurality of through-holes 22 (see FIG. 2(A) and FIG. 2(B)) are formed thereon. The through-hole 22 may be in any shape as square, parallelogram, or circular. A mask pattern is structured relative to the shape, arrangement, and quantity of the through-holes 22. Therefore, the second substrate 20 may be called a screen board.

On the second substrate 20, a second alignment mark 24 is formed. The first and the second substrates 10 and 20 are aligned with each other using the first and the second alignment marks 14 and 24. The second alignment mark 24 may be formed by etching the second substrate 20 or may be formed with a metal film.

A plurality of second substrates 20 are mounted on the first substrate 10. As shown in FIG. 2(A), the second substrate 20 is mounted on the first substrate 10, in that a plurality of through-holes 22 are arranged inside the aperture 12 on the first substrate 10. More precisely, a periphery of the second substrate 20 is mounted along a rim of the aperture 12 of the first substrate 10, and one second substrate 20 is mounted corresponding to one aperture 12. The second substrate 20 is mounted on a surface of the first substrate 10 opposite the surface of the other side where the first alignment mark 14 is formed. In the present embodiment, the first and the second substrates 10 and 20 are laminated with an adhesive agent 91, and the second substrate 20 is composed of a material adhesive to the first substrate 10 (such as silicon).

The adhesive agent 91 is formed partially on a corner of the second substrate 20, which is bonded to the first substrate 10 only at the corner. Therefore, when an adhesive agent is applied along the entire periphery of the second substrate 20, a degree of freedom of the substrates increases in comparison with a structure in which the entire periphery is adhered to the first substrate 10. Even if there is a case in which the second substrate 20 is expanded due to heat or the like in the adhering procedure, a problem of the bending on the second substrate 20 does not easily take place.

Next, FIG. 5 shows a cross sectional pattern view for describing the method for manufacturing the mask in accordance with the present embodiment. Prepared first is the first substrate 10 composed of glass and the second substrate 20 composed of single crystalline silicon. For the formation of the aperture 12 on the first substrate 10, sandblast may be applied. Also, the first alignment mark 14 or the mask-positioning mark 16 on the first substrate 10 may be formed by, for example, sputtering or deposition, or by etching.

On the second substrate 20, a plurality of through-holes 22 are formed. For its formation, etching (e.g. anisotropic etching having crystal-surface orientation dependency) may be applied. A wall surface of the through-hole 22 may be perpendicular to the surface (primary surface) of the second substrate 20 or may be tapered. As shown in FIG. 4, when forming the second substrate 20 using a silicon wafer 26, the second substrate 20 can be obtained by cutting the silicon wafer 26 into a desired shape. By this method, a flatness (greatest height) - (smallest height) of the second substrate 20 is around 5 µm. Further, the second alignment mark 24 on the second substrate 20 may be formed by etching, or by sputtering or deposition, for example.

Next, the adhesive agent 91 is applied to one corner of the periphery of each aperture 12 of the first substrate 10. For the adhesive agent 91, a highly adhesive, epoxy UV curing adhesive agent (light curing resin) with low outgas in vacuum may be employed, or a heat curing resin may be employed. In addition, the adhesive agent 91 may be applied, for example, to one corner of the rectangular second substrate 20 or to both corners of the first substrate 10 and the second substrate 20.

Thus prepared first substrate 10 and the second substrate 20 are then aligned with each other, bonded with the adhesive agent 91 which has been applied thereon. Here, a plurality of second substrates 20 are arranged on one surface of the first substrate 10 in such a way that the second substrates 20 do not overlap one another. Additionally, for their alignment, the first and the second alignment marks 14 and 24 are used. After aligning, the first and the second substrates 10 and 20 are adhered to each other by illuminating the adhesive agent 91.

By this method, the second substrate 20 is reinforced by the first substrate 10, enabling a mask to be manufactured with a high strength. Further, even when expansion or shrinkage occurs on the first and/or the second substrate 10 and/or 20, the expansion or shrinkage on the substrates will be lessened at the non-bonded (non-adhered) part since the adhesive agent 91 is applied to only one corner for bonding, and, therefore, a problem such as the bending on the substrates will be solved. As a result, a gap between a layer-formation object material and the mask will not easily appear, and thereby the mask of the present embodiment having a desired high-precision layer pattern can be formed by, for example, deposition.

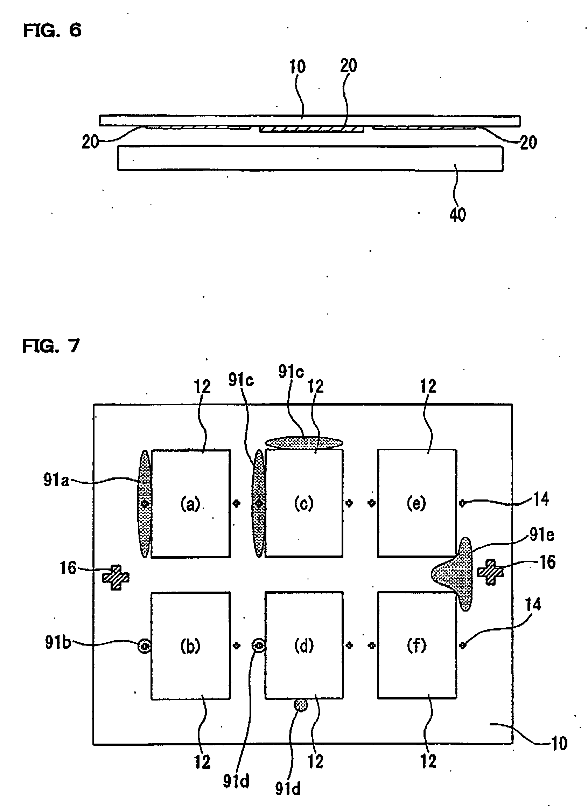

In addition, as shown in FIG. 6, if a plurality of second substrates 20 do not have a uniform height due to a thickness variation appeared thereon, the surfaces of the second substrates 20 may be polished by a whetstone 40 or the like. This enables the flattening of a plurality of the surfaces of the second substrates 20, thereby increasing adhesion to objects to which deposition, for example, is conducted.

FIG. 7 is a diagram showing alternative examples of the present embodiment. That is, it illustrates various places at which the adhesive agent 91 may be applied. An adhesive agent 91a may be applied not only on a corner of the aperture 12 as shown in FIG. 1(A), but also on one side of the aperture 12 as shown in FIG. 7(a). Further, as shown in FIG. 7(b), an adhesive agent 91b may be applied close to the center of one side of the aperture 12.

Furthermore, as shown in FIG. 7(c), an adhesive agent 91c may be applied on more than one side of the aperture 12, particularly only on one side each that opposes the other side. In this case, an adhesive agent 91c is to be applied on two sides constituting a corner. In addition, in this case, the adhesive agent 91d may be applied close to the center of each side of the aperture 12 as shown in FIG. 7(d). In particular, by applying an adhesive agent close to the center of the side having the largest expansion coefficient of all sides of the aperture 12, a degree of freedom of substrates increases further, which can prevent or restrain the bending on the substrates caused by, for example, heat expansion. Further, as shown in FIGs.7 (e) and (f), an adhesive agent 91e may be applied sharing among a plurality of apertures 12.

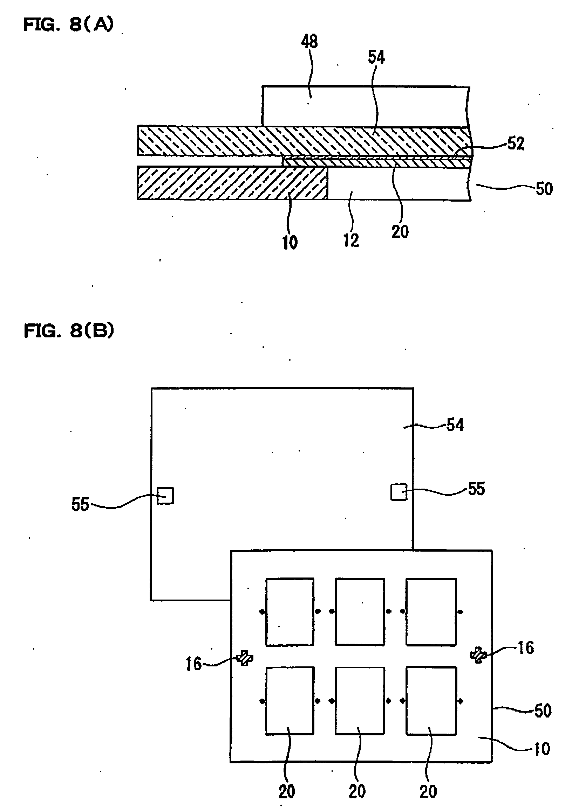

The following FIG. 8(A) and FIG. 8(B) illustrate the method for manufacturing the organic EL in accordance with the embodiment of the present invention. On a mask 50 (e.g. the second substrate 20) shown in FIG. 8(A), a magnetic material layer 52 is formed. The magnetic material layer 52 may be formed with a strongly magnetic material such as ion, cobalt, or nickel. Alternatively, a magnetic metal material such as Ni, Co, Fe, or a stainless steel alloy containing Fe, or a combination of a magnetic metal material and a nonmagnetic metal material may be used to form the magnetic material layer 52. Other details on the mask 50 are as described above.

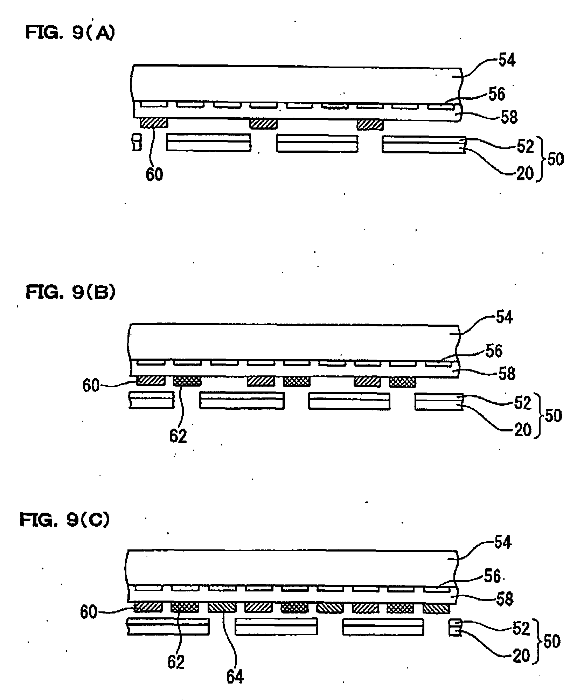

In the present embodiment, a luminescent material is formed into a layer on a substrate (layer-formation object material) 54 using the mask 50. The substrate 54 is used for forming a plurality of organic EL devices and is a transparent substrate such as a glass substrate. On the substrate 54, as shown in FIG. 9(A), an electrode (e.g. a transparent electrode composed of an ITO, for example) 56 or a hole transport layer 58 is formed, or, alternatively, an electron transport layer may be formed.

As shown in FIG. 8(A), the mask 50 is arranged so that the second substrate 20 is placed on one side of the substrate 54. On the other side of the substrate 54, a magnet 48 is placed so as to attract the magnetic material layer 52 formed on the mask 50 (the second substrate 20).

FIG. 8(B) is a diagram for describing the method for positioning the mask. As described above, the mask-positioning mark 16 is formed on the first substrate 10. Also, on the substrate 54, a positioning mark 55 is formed. Using the mask-positioning mark 16 and the positioning mark 55, the first substrate 10 and the substrate 54 are aligned with each other.

From FIG. 9(A) to FIG. 9(C) are diagrams for describing the method for forming a layer using a luminescent material. The luminescent material is an organic material, for example. As a low-molecular organic material, there is tri(8-hydrooxyquinoline) aluminum (Alq₃), and as a high-molecular organic material, there is poly(para-phenylene vinylene) (PPV). The luminescent material may be formed into a layer by deposition. For example, as shown in FIG. 9(A), a red luminescent material is patterned through the mask to form a red luminescent layer 60. Then, as shown in FIG. 9(B), by moving the mask 50 and patterning a green luminescent material, a green luminescent layer 62 is formed. Also, as shown in FIG. 9(C), by moving the mask 50 again and by patterning a blue luminescent material, a blue luminescent layer 64 is formed.

In the present embodiment, the second substrate 20 serving as a screen is partially bonded to the first substrate 10. Therefore, the second substrate 20 has a high degree of freedom and does not easily bend or deform and shows a high repeatability in the selective deposition and high productivity. With the mask 50 of the present embodiment, a plurality of the apertures 12 are formed on the first substrate 10, and the second substrates 20 are placed corresponding to each aperture 12. Each second substrate 20 corresponds to one organic EL device. In other words, by using the mask 50, a plurality of unified organic EL devices can be manufactured. By cutting the substrate 54, separate organic EL devices can be obtained.

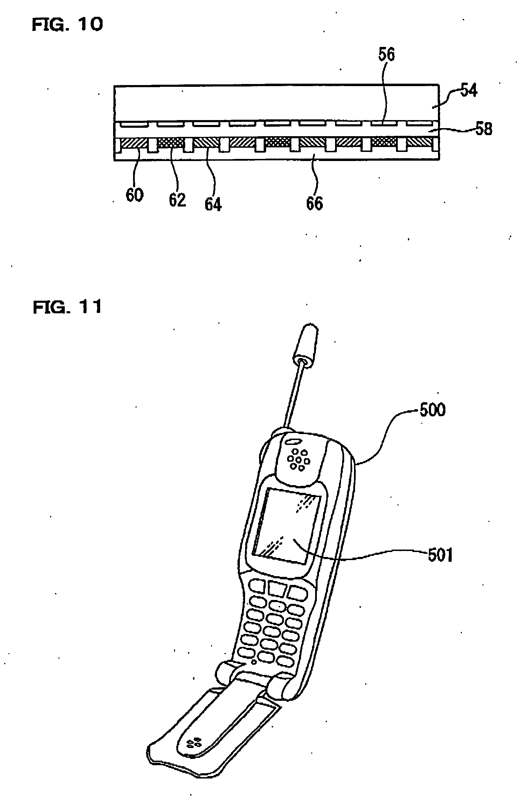

FIG. 10 is a flat pattern view illustrating a rough structure of the organic EL device manufactured by following the above-described method for forming the layers of the luminescent materials. The organic EL device includes the substrate 54, the electrode 56, the hole transport layer 58, and the luminescent layers 60, 62, and 64. On the luminescent layers 60, 62, and 64, an electrode 66 is formed. The electrode 66 is a cathode electrode, for example. The organic EL device such as this is suitable for a display device (or a display), and by using the luminescent layers 60, 62, and 64, a highly reliable display with a very little pattern shifting can be provided.

As an example of an electronic apparatus having the organic EL device, a mobile phone 500 is illustrated in FIG. 11. The mobile phone has a structure having a display unit 501 which includes the organic EL device of the above-described embodiment, thereby a very highly reliable display can be provided.

Additionally, it is to be understood that the present invention is not limited to any of the embodiments as herein described, that modifications can be properly effected within the entire scope and spirit of the invention, and that any method for manufacturing a substrate used for an electro-optical device, any substrate used for electro-optical device, any electro-optical device, and any electronic apparatus associated with such modifications shall be included in the technological scope of the present invention.

### Brief Description of the Drawings

FIG. 1 is a flat pattern view and a cross sectional pattern view showing one embodiment of the mask of the present invention.
FIG. 2 is a flat pattern view and a cross sectional pattern view showing an enlarged principal part of the mask in FIG. 1.
FIG. 3 is a flat pattern view illustrating a rough structure of a first substrate.
FIG. 4 is a flat pattern view illustrating a rough structure of a second substrate.
FIG. 5 is a cross sectional pattern view for describing the method for manufacturing the mask in FIG. 1.
FIG. 6 is a cross sectional pattern view for describing the method for manufacturing the mask in FIG. 1.
FIG. 7 is a flat pattern view showing several altered examples of the mask of the present invention.
FIG. 8 is a flat pattern view and a cross pattern sectional view for describing one method for manufacturing the organic EL in accordance with the present invention.
FIG. 9 is a flat pattern view and a cross sectional pattern view for describing one method for manufacturing the organic EL in accordance with the present invention.
FIG. 10 is a cross sectional pattern view showing one embodiment of the organic EL in accordance with the present invention.
FIG. 11 is a perspective view illustrating one embodiment of an electronic device.

## Claims

1. A mask comprising a first substrate having a first aperture and at least one second substrate having second apertures serving as mask apertures of the mask, wherein the second apertures are placed in the first aperture, and the at least one second substrate is partially bonded to the first substrate.

2. The mask according to Claim 1, wherein the second substrate is bonded to the first substrate using an adhesive agent, the adhesive agent being partially formed on one second substrate.

3. The mask according to Claim 1 or Claim 2, wherein the second substrate is bonded to the first substrate over a plurality of points.

4. The mask according to any one of Claims 1 through 3, wherein the second substrate is formed rectangularly, and only a corner of the second substrate is partially bonded to the first substrate.

5. The mask according to any one of Claims 1 through 4, wherein the second substrate is formed rectangularly, and only one side of each second substrate that opposes the other side of a primary surface of the respective second substrate is partially bonded to the first substrate.

6. The mask according to any one of Claims 1 through 5, wherein the second substrate is partially bonded to the first substrate close to a center of a side having the largest expansion coefficient of all sides of a primary surface of the second substrate.

7. The mask according to any one of Claims 2 through 6, wherein more than two second substrates are bonded to the first substrate sharing the same adhesive agent.

8. The mask according to any one of Claims 1 through 7, wherein an alignment mark used when bonding the second substrate to the first substrate is placed on each substrate, and each substrate is bonded in close proximity to the alignment mark.

9. The mask according to any one of Claims 1 through 8, wherein the second substrate is formed with a silicon wafer.

10. A method for manufacturing a mask, comprising the steps of:
laminating at least one second substrate having second apertures serving as mask apertures to a first substrate having a first aperture so that the second apertures are placed in the first aperture, and
partially bonding the at least one second substrate to the first substrate in the laminating step.

11. The method for manufacturing the mask according to Claim 10, wherein, in the laminating step, the second substrate is bonded to the first substrate using an adhesive agent, and the adhesive agent is partially formed on the first substrate and/or the second substrate.

12. The method for manufacturing the mask according to Claim 10 or Claim 11, wherein a substrate the primary surface of which is rectangular is used as the second substrate, and, in the laminating step, only a corner of the second substrate is partially bonded.to the first substrate.

13. The method for manufacturing the mask according to any one of the Claims 10 through 12, wherein a substrate the primary surface of which is rectangular is used as the second substrate, and, in the laminating step, only one side of each second substrate that opposes the other side of a primary surface of the respective second substrate is partially bonded to the first substrate.

14. The method for manufacturing the mask according to Claim 10, wherein, in the laminating step, the second substrate is partially bonded to the first substrate close to a center of a side having the largest expansion coefficient of all sides of a primary surface of the second substrate.

15. A method of manufacturing an organic electroluminescent device, wherein an organic electroluminescent element is formed using the mask according to any one of the Claims 1 through 9.

16. The method for manufacturing the organic electroluminescent device according to Claim 15, wherein a luminescent layer-formation material is formed into a predetermined pattern using the mask.

17. An organic electroluminescent device obtained by the method for manufacturing thereof according to Claim 15 or 16.
